# EUROPEAN PATENT SPECIFICATION

(11) **EP 3 159 932 B1**
(45) Date of publication and mention of the grant of the patent: **01.09.2021**
(21) Application number: 15811392.8
(22) Date of filing: 17.06.2015
(51) Int. Cl.: H01L 29/861, H01L 29/417, H01L 29/16, H01L 21/205, H01L 21/28, H01L 21/329, H01L 29/06, H01L 29/868, H01L 29/08, H01L 21/04, H01L 29/40

(54) **DIAMOND SEMICONDUCTOR DEVICE, AND METHOD FOR PRODUCING SAME**
HALBLEITERBAUELEMENT AUS DIAMANT UND VERFAHREN ZUR HERSTELLUNG DAVON
DISPOSITIF À SEMI-CONDUCTEURS EN DIAMANT ET SON PROCÉDÉ DE FABRICATION

(30) Priority: 23.06.2014 JP 2014128021
(43) Date of publication of application: 26.04.2017
(73) Proprietor: Kabushiki Kaisha Toshiba, Minato-ku Tokyo 105-8001 (JP)
(72) Inventor: SUZUKI, Mariko, Tokyo 105-8001 (JP); SAKAI, Tadashi, Kawasaki Kanagawa 212-8582 (JP)
(74) Representative: Moreland, David
(86) International application number: PCT/JP2015/067513
(87) International publication number: WO 2015/198950

(56) References cited:
- EP-A1- 1 081 747
- EP-A2- 0 519 472
- EP-A2- 0 643 423
- JP-A- H05 891
- JP-A- H04 242 922
- JP-A- H06 275 554
- JP-A- H06 275 554
- JP-A- 2009 260 278
- US-A1- 2005 258 483
- US-A1- 2011 260 175
- US-A1- 2012 228 734
- None

## Description

### [Field]

The invention relates to a diamond semiconductor device and a method for manufacturing the same.

### [BACKGROUND]

A semiconductor device using diamond has been proposed. The semiconductor device is desired to have a high breakdown voltage.

### [Citation List]

### [Patent Literature]

EP 1 081 747 describes a diamond pn junction diode including a p-type diamond thin-film layer formed on a substrate and an n-type diamond thin-film layer formed by forming a high-quality undoped diamond thin-film layer on the p-type diamond thin-film layer and ion-implanting an impurity into the high-quality undoped diamond thin-film layer, or alternatively includes an n-type diamond thin-film layer formed on a substrate and a p-type diamond thin-film layer formed by forming a high-quality undoped diamond thin-film layer on the n-type diamond thin-film layer and ion-implanting an impurity into the high-quality undoped diamond thin-film layer.

US 2005/258483 describes a power semiconducting device made from a semiconducting material epitaxied on a stacked structure comprising a layer of semiconducting material transferred onto a first face of a support substrate and fixed to the support substrate by an electrically insulating layer, the support substrate comprising electrically conducting means between said first face and a second face, the transferred layer of semiconducting material acting as an epitaxy support for the epitaxied semiconducting material.

EP 0 519 472 describes a diamond product comprising a semiconductor layer having an outer surface region of graphite in contact with the metal electrode to form an ohmic junction with the metal electrode, wherein the outer surface region of graphite has a thickness of at least about 12 ANGSTROM.

JP H06 275554 discloses an electrode constituted of a metal carbide layer which is formed on a semiconductor diamond layer and composed of chrome carbide, molybdenum carbide, tungsten carbide, titanium carbide, tantalum carbide, vanadium carbide, hafnium carbide, zirconium carbide, or zirconium carbide synthesized through a reaction to the layer and an electrode layer which is formed on the layer and composed of a conductive material other than the metal constituting the layer.

EP 0 643 423 describes a diamond semiconductor device comprising an n-type diamond layer to which an n-type dopant is doped at high concentration so that metal conduction dominates, a p-type diamond layer to which a p-type dopant is doped at high concentration so that metal conduction dominates, and a high resistance diamond layer formed between the n-type diamond layer and the p-type diamond layer.

[PTL 1] JP2009-200110A

### [Summary of Invention]

### [Technical Problem]

An embodiment of the present invention provides a semiconductor device having a high breakdown voltage and a method for manufacturing the same.

According to one embodiment, there is provided a semiconductor device as recited in claim 1. According to another embodiment, there is provided a method for manufacturing a semiconductor device according to claim 12.

### [Brief Description of Drawings]

[Fig. 1]

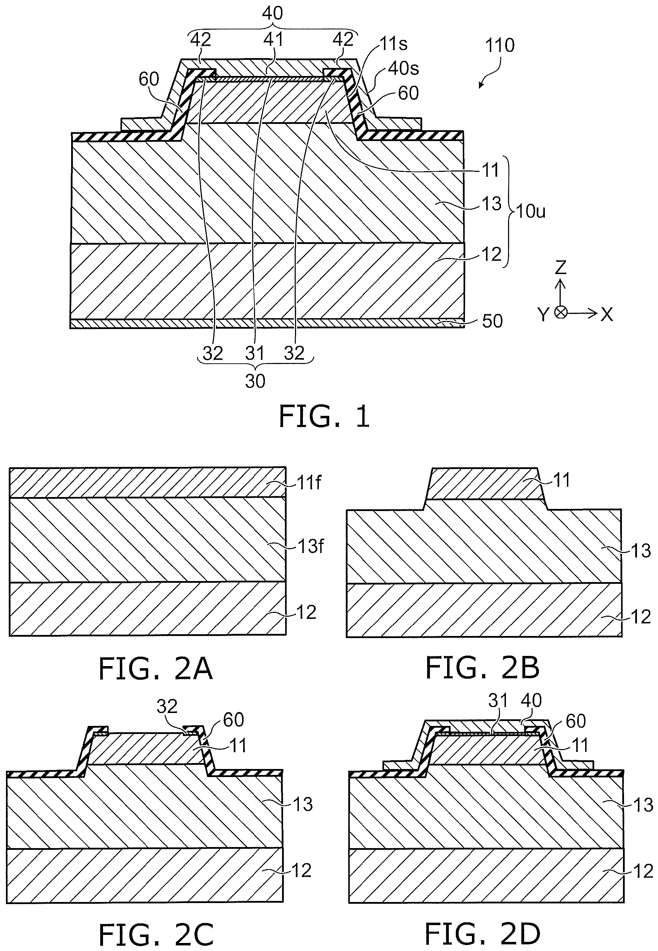

   FIG. 1 is a schematic cross-sectional view illustrating a semiconductor device according to a first embodiment.
[Fig. 2]
   FIG. 2A to FIG. 2D are process order schematic cross-sectional views illustrating a method for manufacturing the semiconductor device according to the first embodiment.
[Fig. 3]

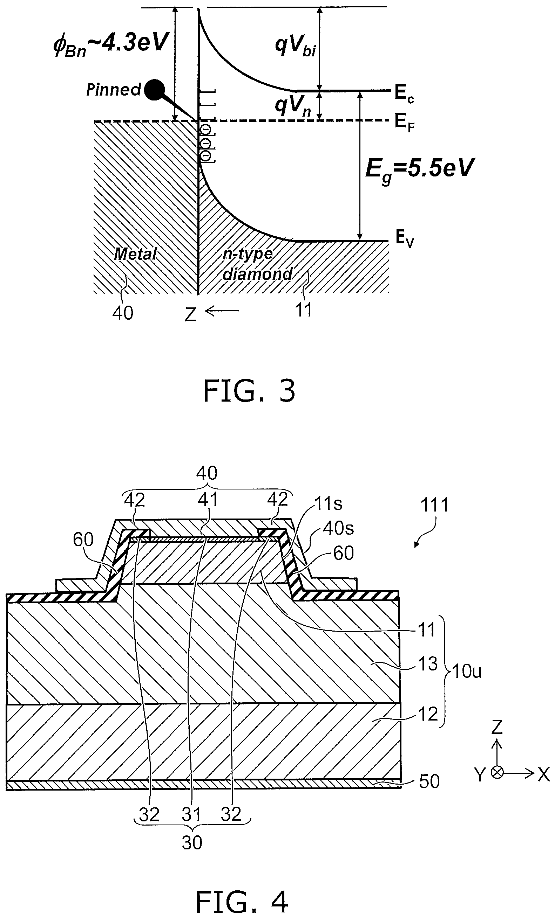

   FIG. 3 is a schematic view illustrating a characteristic of the semiconductor device.
[Fig. 4]
   FIG. 4 is a schematic cross-sectional view illustrating a semiconductor device according to a second embodiment.
[Fig. 5]

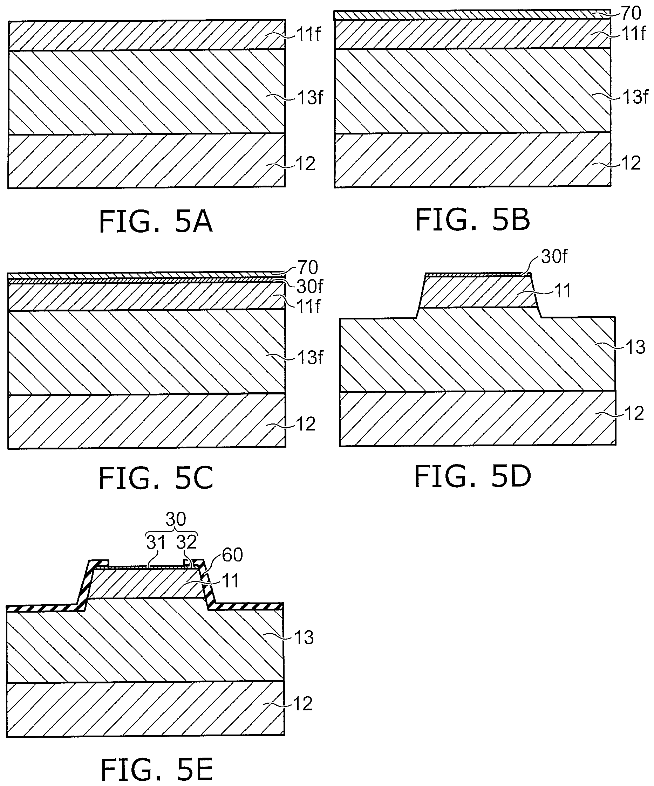

   FIG. 5A to FIG. 5E are process order schematic cross-sectional views illustrating a method for manufacturing the semiconductor device according to the second embodiment.
[Fig. 6]

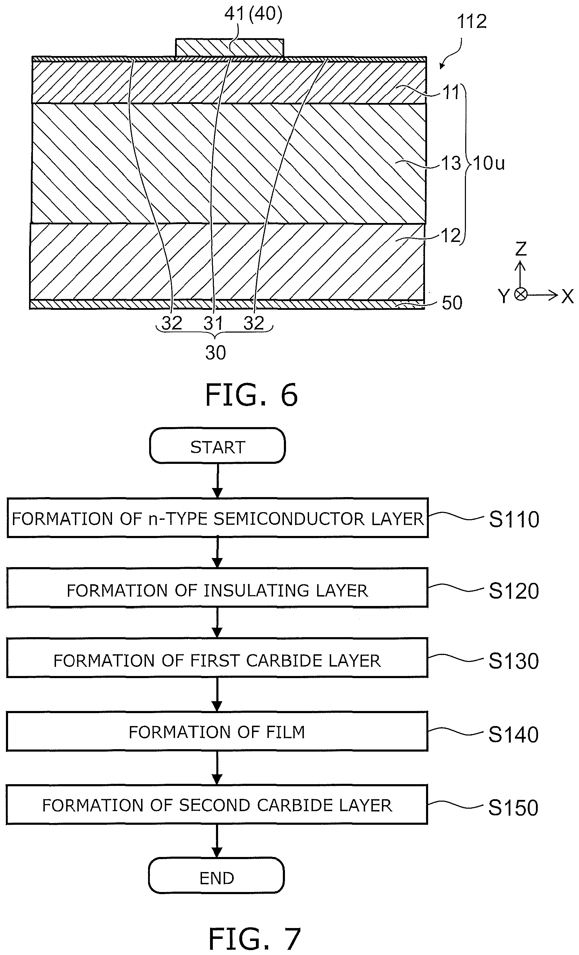

   FIG. 6 is a schematic cross-sectional view illustrating a semiconductor device according to an example useful for understanding the present invention.
[Fig. 7]
   FIG. 7 is a flowchart illustrating a method for manufacturing a semiconductor device according to a third embodiment.
[Fig. 8]

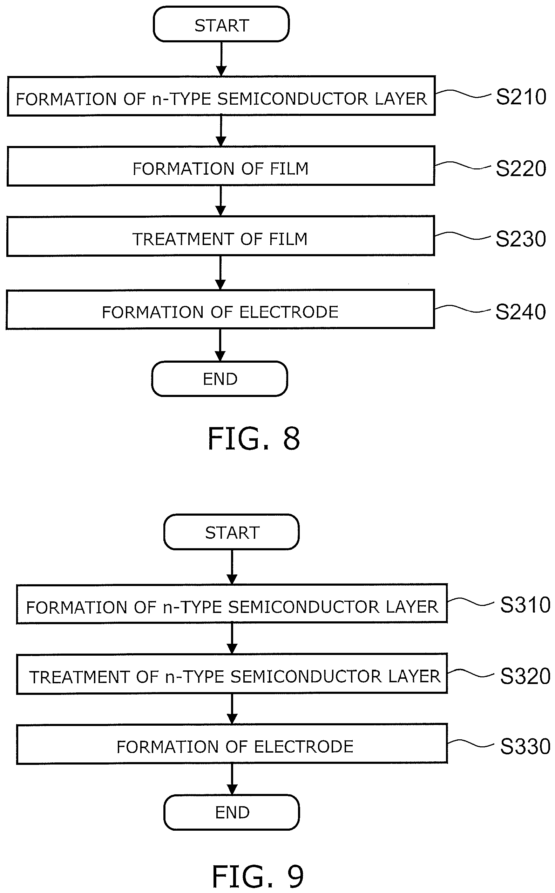

   FIG. 8 is a flowchart illustrating a method for manufacturing a semiconductor device useful for understanding the present invention.
[Fig. 9]
   FIG. 9 is a flowchart illustrating a further method for manufacturing a semiconductor device useful for understanding the present invention.

Various embodiments will be described hereinafter with reference to the accompanying drawings.

The drawings are schematic and conceptual; and the relationships between the thickness and width of portions, the proportions of sizes among portions, etc., are not necessarily the same as the actual values thereof. Further, the dimensions and proportions may be illustrated differently among drawings, even for identical portions.

In the specification and drawings, components similar to those described or illustrated in a drawing therein above are marked with like reference numerals, and a detailed description is omitted as appropriate.

Even though below other intermediate layers are discussed, according to invention a carbide intermediate layer as defined in claims 1 and 12 is formed.

### (First Embodiment)

FIG. 1 is a schematic cross-sectional view illustrating a semiconductor device according to a first embodiment.

As shown in FIG. 1, a semiconductor device 110 according to the embodiment includes an n-type semiconductor layer 11, a p-type semiconductor layer 12, a first electrode 40, and an intermediate layer 30.

A direction from the n-type semiconductor layer 11 to the first electrode 40 is defined as a stacking direction (Z-axis direction). One direction perpendicular to the Z-axis direction is defined as an X-axis direction. A direction perpendicular to the Z-axis direction and the X-axis direction is defined as a Y-axis direction. An X-Y plane is a plane perpendicular to the stacking direction (Z-axis direction).

The p-type semiconductor layer 12 is electrically connected to the n-type semiconductor layer 11. In the specification, an electrically connected state includes a direct contact state and a state in which another layer is inserted therebetween. The electrically connected state includes a state capable of forming a state in which a current flows in at least one direction.

The n-type semiconductor layer 11 and the p-type semiconductor layer 12 contain diamond. The semiconductor device 110 is a semiconductor device using diamond as a semiconductor layer.

In this example, an intermediate semiconductor layer 13 is further provided. The intermediate semiconductor layer 13 is provided between the p-type semiconductor layer 12 and the n-type semiconductor layer 11 and contains diamond. The impurity concentration in the intermediate semiconductor layer 13 is lower than the impurity concentration in the p-type semiconductor layer 12. The impurity concentration in the intermediate semiconductor layer 13 is lower than the impurity concentration in the n-type semiconductor layer 11.

The n-type semiconductor layer is an n⁺ layer, and the p-type semiconductor layer is a p⁺ layer. The intermediate semiconductor layer 13 is a p⁻ layer. Alternatively, the intermediate semiconductor layer 13 may be, for example, an intrinsic semiconductor.

These semiconductor layers are included in a stacked body 10u having a p-n junction. In the embodiment, the p-n junction includes a stacked body of a p-type layer and an n-type layer. In the embodiment, a case where a layer having a low impurity concentration is provided between the p-type layer and the n-type layer is also included in the stacked body having a p-n junction.

In this example, in the stacked body 10u, a mesa structure is provided. That is, the n-type semiconductor layer 11 has a side surface 11s intersecting the X-Y plane. In this example, the side surface 11s is inclined with respect to the Z-axis direction.

A current flows between the first electrode 40 and the n-type semiconductor layer 11. The first electrode 40 is an ohmic electrode. The first electrode 40 includes a first portion 41. The first portion 41 of the first electrode 40 is a contact portion with the n-type semiconductor layer 11.

The intermediate layer 30 includes a first region 31 and a second region 32. The first region 31 is provided between the first portion 41 and the n-type semiconductor layer 11. The first region 32 is provided around the first region 31 when projected on the X-Y plane and does not overlap the first portion 41. The second region 32 is continuous with the first region 31. In the embodiment, the first region 31 and the second region 32 are in contact with the n-type semiconductor layer 11.

The intermediate layer 30 is conductive. A current flows between the first portion 41 of the first electrode 40 and the n-type semiconductor layer 11 through the first region 31 of the intermediate layer 30.

The intermediate layer 30 contains at least a carbide. In an example useful for understanding the present invention, the intermediate layer 30 contains at least any of graphite, graphene, and amorphous carbon. The carbide is a carbide containing at least any of Ti, Si, Al, W, Ni, Cr, Ca, Li, Ru, Mo, Zr, Sr, Co, Rb, K, Cu, and Na.

According to the invention the first region contains a carbide containing carbon and an element from the first electrode 40 and the second region a carbide containing carbon and an element contained in the insulating layer 60. As will be described later, in the first region 31 and the second region 32 of the intermediate layer 30, materials may be the same or different.

In this example, the first electrode 40 further includes a second portion 42. Then, an insulating layer 60 is further provided. The second portion 42 is provided around the first portion 41 when projected on the X-Y plane. The second portion 42 is continuous with the first portion 41. The second portion 42 includes, for example, a pad portion provided around the contact portion.

At least a part of the insulating layer 60 is provided between the second portion 42 and the n-type semiconductor layer 11. Specifically, the insulating layer 60 is disposed between the second portion 42 and the second region 32.

In this example, the second portion 42 of the first electrode 40 is provided covering the side surface 11s of the n-type semiconductor layer 11. That is, the first electrode 40 incudes a portion 40s (for example, a part of the second portion 42) facing the side surface 11s of the n-type semiconductor layer 11. The insulating layer 60 extends between the side surface 11s of the n-type semiconductor layer 11 and the above-mentioned facing portion 40s (a part of the second portion 42) of the first electrode 40. That is, the insulating layer 60 is provided so as to cover the side surface 11s of the n-type semiconductor layer 11, and the first electrode 40 is provided on such an insulating layer 60. By covering the side surface 11s of the n-type semiconductor layer 11 with the insulating layer 60, for example, the reliability is improved. The insulating layer 60 functions as a protective layer.

As will be described later, in an example useful for understanding the present invention, the second portion 42 and the insulating layer 60 may be omitted.

In this example, between the first electrode 40 and the p-type semiconductor layer 12, the n-type semiconductor layer 11 is disposed. Then, a second electrode 50 is further provided. The second electrode 50 is electrically connected to the p-type semiconductor layer 12. Between the first electrode 40 and the second electrode 50, the n-type semiconductor layer 11 is disposed. Between the n-type semiconductor layer 11 and the second electrode 50, the p-type semiconductor layer 12 is disposed.

Hereinafter, an example of a method for manufacturing the semiconductor device 110 will be described.

FIG. 2A to FIG. 2D are process order schematic cross-sectional views illustrating a method for manufacturing the semiconductor device according to the first embodiment.

As shown in FIG. 2A, on the p-type semiconductor layer 12 (for example, a p-type diamond substrate), an undoped intrinsic semiconductor diamond layer 13f to become the intermediate semiconductor layer 13 is formed, and thereon, an n-type diamond layer 11f to become the n-type semiconductor layer 11 is formed. In the formation of these layers, for example, a microwave plasma CVD (Chemical Vapor deposition) method is used.

As shown in FIG. 2B, a mesa structure is formed by removing a part of the undoped intrinsic semiconductor diamond layer 13f and a part of the n-type diamond layer 11f. In the removal of these, for example, patterning and RIE (Reactive Ion Etching) are used. By doing this, the intermediate semiconductor layer 13 and the n-type semiconductor layer 11 are formed.

As shown in FIG. 2C, the insulating layer 60 is formed. For example, a silicon oxide film to become the insulating layer 60 is formed by, for example, CVD. A part of the silicon oxide film is removed by patterning and etching. By doing this, the insulating layer 60 is formed.

Thereafter, a heat treatment is performed. The heat treatment is performed in, for example, air. The temperature is, for example, 1000°C or higher and 1500°C or lower, and is, for example, 1300°C. The time is 10 minutes or more and 60 minutes or less, and is, for example, 30 minutes. By this heat treatment, a portion in contact with the insulating layer 60 of the n-type semiconductor layer 11 is altered. For example, a compound containing Si contained in the insulating layer 60 and C (carbon) contained in the n-type semiconductor layer 11 is formed. For example, a SiC layer is formed. This SiC layer becomes a part (the second region 32) of the intermediate layer 30.

As shown in FIG. 2D, the first electrode 40 is formed. For example, a conductive film to become the first electrode 40 is formed. As the conductive film, for example, a Ti/Pt/Au stacked film is used. In the formation of the stacked film, for example, electron beam vapor deposition is used. The Ti film is in contact with the n-type semiconductor layer 11 which is not covered with the insulating layer 60. This conductive film is patterned. By doing this, the first electrode 40 is formed.

Thereafter, annealing is performed. The annealing temperature is, for example, 500°C or higher and 700°C or lower, and is, for example, 600°C. The annealing time is 10 minutes or more and 60 minutes or less, and is, for example, 30 minutes. By this annealing, a TiC layer is formed from Ti in the conductive film and carbon in the n-type semiconductor layer 11. This TiC layer becomes a part (the first region 31) of the intermediate layer 30. By the above-mentioned process, the semiconductor device 110 is formed.

As the impurity in the p-type semiconductor layer 12, for example, boron is used. The concentration of boron in the p-type semiconductor layer 12 is, for example, 1 × 10²⁰ cm⁻³ or more and 1 × 10²¹ cm⁻³ or less, and is, for example, 5 × 10²⁰ cm⁻³. As the impurity in the n-type semiconductor layer 11, for example, phosphorus is used. The concentration of phosphorus in the n-type semiconductor layer 11 is, for example 5 × 10¹⁹ cm⁻³ or more and 5 × 10²⁰ cm⁻³ or less, and is, for example, 1 × 10²⁰ cm⁻³. In this example, the concentration of the impurity in the intermediate semiconductor layer 13 is lower than the lower detection limit of secondary ion mass spectrometry (SIMS), and is, for example, less than 1 × 10¹⁵ cm⁻³.

In the semiconductor device 110, as the first region 31, a TiC layer is provided, and as the second region 32, a SiC layer is provided. The first region 31 and the second region 32 function as electric field relaxation layers.

In the current-voltage characteristic (I-V characteristic) of the semiconductor device 110, a rectification ratio at ±10 V is, for example, 1 × 10¹⁰ or more. A forward current density at 10 V is, for example, 1000 A/cm² or more. Also in the case where a reverse voltage is 10 kV, breakdown does not occur.

According to the semiconductor device 110 according to the embodiment, a semiconductor device having a high breakdown voltage can be provided.

Diamond is rigid and has a high thermal conductivity (20 W/cmK). The bandgap energy of diamond is 5.5 eV, and diamond is a wide gap semiconductor. Diamond has a high carrier mobility and has an electron mobility of about 4500 cm²/Vsec and a hole mobility of about 3800 cm²/Vsec. The breakdown field strength of diamond is high and is expected to be 10 MV/cm. Diamond is expected to be applied to power devices, high-frequency (power) devices, ultraviolet optical devices, electron emission sources, and the like, which can be operated even at a high temperature. As found from the comparison of the figures of merit (Baliga's figures of merit) of power devices, diamond is expected to greatly improve the performance of the power devices as compared with SiC and GaN.

There have been studied diodes and transistors having a Schottky junction using diamond so far. However, the breakdown voltage limitations are limited depending on the Schottky barrier height. Due to this, it is difficult to obtain a breakdown voltage of 10 kV or more.

On the other hand, in a pin diode having a bipolar conduction mechanism, a reverse breakdown voltage is determined by a depletion layer (that is, an i layer) at a p-n junction interface. Due to this, it is possible to utilize the original high breakdown field of diamond. Also for a forward current, a very high mobility is obtained in the diamond i layer, and therefore, a high conductivity can be expected even if the i layer is made thick. The contact resistance to the n-type layer is reduced by high-concentration doping, and ohmic contact can be achieved.

However, the reports on pin diodes are mostly intended for light-emitting elements, and the reverse breakdown voltage is very small as compared with a value originally expected for diamond.

In a Schottky diode, an electric field is concentrated on an electrode end, and therefore, in order to improve the breakdown voltage, a field concentration relaxation structure such as a field plate or a guard ring has been studied. However, in a pin diode, in general, the maximum electric field is applied to a p-n interface, and in particular, there is a problem that an electric field is concentrated on a junction end, and therefore, the field relaxation structure has been studied for a JTE structure (junction end structure) not at an electrode end, but at a p-n junction end.

It was found that in a diamond pin diode, an electrode end breaks down prior to the breakdown at a p-n junction end at a voltage such that a large field strength exceeding 3 MV/cm is applied to a drift layer. This is considered to be attributed to a surface state specific to diamond.

FIG. 3 is a schematic view illustrating a characteristic of the semiconductor device.

FIG. 3 illustrates the band states of diamond and a metal. As shown in FIG. 3, on the surface of n-type diamond (for example, the n-type semiconductor layer 11), the Fermi level is firmly pinned. In the n-type diamond immediately beneath the electrode (metal), immediately after depositing a metal film, a Schottky junction is formed, however, by forming TiC or the like by annealing, pinning at an interface between the n-type diamond and the metal is relaxed. By doing this, a contact resistance can be reduced.

On the other hand, in a region other than the region immediately beneath the electrode in the n-type diamond, the Fermi level is still firmly pinned on the surface of diamond. Due to this, when a voltage is applied, an electric field is generated between an electrode portion and the surface of diamond around the electrode portion (and in the vicinity thereof). Then, when a high voltage is applied, the field strength becomes very high in this portion. It is considered that breakdown occurs due to this. This phenomenon is considered to be a phenomenon occurring specially in diamond on which the Fermi level is firmly pinned.

For example, in the case where Ti is used as an ohmic electrode, TiC is formed on an interface between an electrode immediately beneath the electrode and diamond. Due to this, the pinning of the Fermi level on the surface of the n-type diamond immediately beneath the electrode is relaxed. On the other hand, on the surface of the n-type diamond in a portion in which the electrode is not provided, the Fermi level is still firmly pinned.

Diamond has a high surface level density and a low dielectric constant as compared with GaN. Therefore, it is difficult to relax the electric field distribution. Due to this, for diamond, for example, a method different from a field plate or the like is required. For example, it is considered to be effective for diamond to change the surface state.

In the embodiment, an intermediate layer is provided on the surface of diamond around the end of the n-side electrode. According to this, a semiconductor device of diamond having a high breakdown voltage can be provided. The embodiment provides a semiconductor device of diamond having a characteristic of a high breakdown voltage (for example, 10 kV or more) with high reproducibility.

In the embodiment, for example, in a semiconductor device having a diamond p-n junction, on the surface of the n-type diamond in the vicinity of an end of an n-side electrode (the first electrode 40), an intermediate layer (the second region 32 of the intermediate layer 30) is provided. This intermediate layer includes a layer of at least a carbide. In an example useful for understanding the present invention, this intermediate layer includes a layer of at least any of a graphite, graphene, and amorphous carbon. Such an intermediate layer may be provided between the n-type diamond and an insulating protective film (the insulating layer 60).

According to the embodiment, pinning of the Fermi level on the surface of the n-type diamond can be suppressed. According to this, an electric field is suppressed between the electrode and the n-type diamond around the electrode, and the electric field concentration on the end of the electrode is relaxed.

When a carbide is provided between the electrode and the n-type diamond, the contact resistance is reduced. By providing a carbide between the electrode and the n-type diamond, the pinning of the Fermi level can be suppressed.

For example, the n-type diamond immediately beneath the electrode is transformed into TiC. For example, by annealing, ion injection, or the like, the diamond can be graphitized.

For example, as the second region 32 of the intermediate layer 30, a film containing carbon having a non-sp3 structure such as a carbide or graphite is provided. According to this, the firm pinning of the Fermi level on the surface of the n-type diamond can be relaxed. An electric field generated between the electrode and the n-type diamond around the electrode can be relaxed. The breakdown voltage of the semiconductor device can be increased.

In the embodiment, as the intermediate semiconductor layer 13, a p⁻ layer containing boron at a low concentration may be used.

In the embodiment, the thickness (the length in the Z-axis direction) of the intermediate layer 30 is 1 nanometer (nm) or more and 10 nm or less. Each of the thickness of the first region 31 and the thickness of the second region 32 is 1 nm or more and 10 nm or less. When the thickness is thinner than 1 nm, for example, the resistance of the intermediate layer 30 becomes excessively high. For example, it becomes difficult to relax the pinning at an interface between the n-type diamond and the metal. When the thickness is thicker than 10 nm, for example, the intermediate layer 30 is likely to be inhomogeneous.

In the embodiment, as the insulating layer 60, for example, aluminum oxide (for example, Al₂O₃) or the like may be used. In this case, for example, as the second region 32 of the intermediate layer 30 is aluminum carbide.

In the semiconductor device 110, the first region 31 and the second region 32 of the intermediate layer 30 contain materials (elements) different from each other. In the above-mentioned example, the first region 31 contains an element (in the above-mentioned example, Ti) contained in the first electrode 40. The second region 32 contains an element (in the above-mentioned example, Si or Al) contained in the insulating layer 60.

For example, the insulating layer 60 contains an oxide of silicon. At this time, for example, the first region 31 contains TiC. The second region 32 contains SiC. For example, the first region 31 of the intermediate layer 30 contains a compound containing carbon contained in the n-type semiconductor layer 11 and an element contained in the first potion 41 of the first electrode 40.

In the embodiment, as the insulating layer 60, at least any of silicon oxide, silicon nitride, aluminum oxide, aluminum nitride, zirconium oxide, hafnium oxide, and titanium oxide may be used.

### (Second Embodiment)

In the embodiment, in the first region 31 and the second region 32 of the intermediate layer 30, the same material is used.

FIG. 4 is a schematic cross-sectional view illustrating a semiconductor device according to a second embodiment.

As shown in FIG. 4, also in a semiconductor device 111 according to the embodiment, an intermediate layer 30 is provided between an n-type semiconductor layer 11 and a first electrode 40. The intermediate layer 30 includes a first region 31 and a second region 32. A portion located between a first portion 41 of the first electrode 40 and an n-type semiconductor layer 11 becomes the first region 31. A portion located between an insulating layer 60 and the n-type semiconductor layer 11 becomes the second region 32. In the first region 31 and the second region 32, the same material (TiC or the like) is used. The configuration other than this can be the same as described with respect to the first embodiment, and therefore, a description thereof will be omitted.

Between the first region 31 and the second region 32, a boundary is not observed in some cases. The position of the outer edge of the first portion 41 of the first electrode 40 (a boundary between the first portion 41 and the second portion 42) corresponds to the position of an end portion of the insulating layer 60. By the end portion of the insulating layer 60, the boundary between the first portion 41 and the second portion 42 is found, and a boundary between the first region 31 and the second region 32 is found.

Also in the semiconductor device 111, around the first portion 41 of the first electrode 40, the second region 32 of the intermediate layer 30 is provided. According to this, the firm pinning of the Fermi level on the surface of the n-type diamond can be relaxed. Then, an electric field generated between the electrode and the n-type diamond around the electrode can be relaxed. Also in the semiconductor device 111, a high breakdown voltage can be obtained.

Hereinafter, an example of a method for manufacturing the semiconductor device 111 will be described. Hereinbelow, a part described with respect to the first embodiment will be omitted as appropriate.

FIG. 5A to FIG. 5E are process order schematic cross-sectional views illustrating a method for manufacturing the semiconductor device according to the second embodiment. This example method differs from the method of the invention mainly by the sequence of manufacturing steps.

As shown in FIG. 5A, on the p-type semiconductor layer 12, an undoped intrinsic semiconductor diamond layer 13f is formed, and thereon, an n-type diamond layer 11f is formed.

As shown in FIG. 5B, on the n-type diamond layer 11f, a metal film 70 is formed. For example, as the metal film 70, for example, a Ti/Pt/Au stacked film is formed by electron beam vapor deposition or the like.

As shown in FIG. 5C, annealing is performed. The annealing is performed in, for example, air. The annealing temperature is, for example, 500°C or higher and 700°C or lower, and is, for example, 600°C. The annealing time is 10 minutes or more and 60 minutes or less, and is, for example, 30 minutes. By doing this, a TiC layer 30f is formed from Ti contained in the Ti film and C (carbon) contained in the n-type diamond layer 11f. The TiC layer 30f becomes the first region 31 and the second region 32 of the intermediate layer 30.

The Ti/Pt/Au stacked film is removed by an acid treatment or the like. The TiC layer 30f is left.

As shown in FIG. 5D, a mesa structure is formed by removing a part of the TiC layer 30f, a part of the undoped intrinsic semiconductor diamond layer 13f, and a part of the n-type diamond layer 11f. For example, patterning and RIE are performed. The intermediate semiconductor layer 13 and the n-type semiconductor layer 11 are formed.

As shown in FIG. 5E, the insulating layer 60 is formed. A portion located between the insulating layer 60 and the n-type semiconductor layer 11 of the TiC layer 30f becomes the second region 32 of the intermediate layer 30. A portion other than this becomes the first region 31. A heat treatment may be performed as needed.

Thereafter, the first electrode 40 is formed. By the above-mentioned process, the semiconductor device 110 is formed.

The impurity and the impurity concentration in the p-type semiconductor layer 12, the impurity and the impurity concentration in the n-type semiconductor layer 11, and the impurity concentration in the intermediate semiconductor layer 13 are the same as described with respect to the first embodiment.

In the semiconductor device 111, as the first region 31 and the second region 32, TiC layers are provided. The first region 31 and the second region 32 function as electric field relaxation layers.

In the I-V characteristic of the semiconductor device 111, a rectification ratio at ±10 V is, for example, 1 × 10¹⁰ or more. A forward current density at 10 V is, for example, 1000 A/cm² or more. Also in the case where a reverse voltage is 10 kV, breakdown does not occur. In this manner, also in the semiconductor device 111, a high breakdown voltage can be obtained.

### (Example)

In this example useful for understanding the present invention, the insulating layer 60 is omitted.

FIG. 6 is a schematic cross-sectional view illustrating a semiconductor device according to an example useful for understanding the present invention.

As shown in FIG. 6, also in a semiconductor device 112 according to the example, an intermediate layer 30 is provided between an n-type semiconductor layer 11 and a first electrode 40. The intermediate layer 30 includes a first region 31 and a second region 32. In the first electrode 40, a first portion 41 is provided. A portion located between the first portion 41 of the first electrode 40 and an n-type semiconductor layer 11 becomes the first region 31. A region which does not overlap the first portion 41 when projected on the X-Y plane becomes the second region 32.

Also in the semiconductor device 112, around the first portion 41 of the first electrode 40, the second region 32 of the intermediate layer 30 is provided. According to this, the firm pinning of the Fermi level on the surface of the n-type diamond can be relaxed. Then, an electric field generated between the electrode and the n-type diamond around the electrode can be relaxed. Also in the semiconductor device 112, a high breakdown voltage can be obtained.

Also in this example, in the first region 31 and the second region 32, the same material may be used, or different materials may be used. The outer edge of the first portion 41 corresponds to a boundary between the first region 31 and the second region 32.

In the fabrication of the semiconductor device 112, the method described with respect to the first embodiment or the second embodiment is modified and can be applied.

### (Third Embodiment)

The embodiment relates to a method for manufacturing a semiconductor device.

FIG. 7 is a flowchart illustrating a method for manufacturing a semiconductor device according to a third embodiment.

As shown in FIG. 7, on a p-type semiconductor layer 12 containing diamond, an n-type semiconductor layer 11 containing diamond is formed (Step S110). Before forming the n-type semiconductor layer 11, an intermediate semiconductor layer 13 may be formed.

On a part of the n-type semiconductor layer 11, an insulating layer 60 is formed (Step S120).

By performing a heat treatment, a first carbide layer (a second region 32 of an intermediate layer 30) is formed (Step S130). The first carbide layer contains carbon contained in the n-type semiconductor layer 11 and an element contained in the insulating layer 60.

On the n-type semiconductor layer 11 which is not covered with the insulating layer 60, a film (a film to become a first electrode 40) is formed (Step S140). This film contains at least any of Ti, Si, Al, W, Ni, Cr, Ca, Li, Ru, Mo, Zr, Sr, Co, Rb, K, Cu, and Na.

By subjecting the above film to a treatment, a second carbide layer (a first region 31 of the intermediate layer 30) is formed between the n-type semiconductor layer 11 which is not covered with the insulating layer 60 and the film (Step S150). The second carbide layer contains the above-mentioned at least any of Ti, Si, Al, W, Ni, Cr, Ca, Li, Ru, Mo, Zr, Sr, Co, Rb, K, Cu, and Na.

That is, for example, the treatments described with respect to FIG. 2A to FIG. 2D are performed. By doing this, a semiconductor device 110 is formed.

### (Example)

The example relates to a method for manufacturing a semiconductor device.

FIG. 8 is a flowchart illustrating a method for manufacturing a semiconductor device according to an example.

As shown in FIG. 8, on a p-type semiconductor layer 12 containing diamond, an n-type semiconductor layer 11 containing diamond is formed (Step S210). Before forming the n-type semiconductor layer 11, an intermediate semiconductor layer 13 may be formed.

On the n-type semiconductor layer 11, a film (for example, a metal film 70 described with respect to FIG. 5B) is formed (Step S220). This film contains at least any of Ti, Si, Al, W, Ni, Cr, Ca, Li, Ru, Mo, Zr, Sr, Co, Rb, K, Cu, and Na.

By subjecting this film to a treatment, an intermediate layer 30 is formed (Step S230). The treatment includes, for example, a heat treatment. This intermediate layer 30 contains a carbide containing the above-mentioned at least any of Ti, Si, Al, W, Ni, Cr, Ca, Li, Ru, Mo, Zr, Sr, Co, Rb, K, Cu, and Na. The above-mentioned film (metal film 70) is removed as needed.

On a part of the intermediate layer 30, an electrode (first electrode 40) is formed (Step S240).

For example, the treatments described with respect to FIG. 5A to FIG. 5D are performed. By doing this, a semiconductor device 111 can be formed.

### (Example)

The example relates to a method for manufacturing a semiconductor device.

FIG. 9 is a flowchart illustrating a method for manufacturing a semiconductor device according to another example.

As shown in FIG. 9, on a p-type semiconductor layer 12 containing diamond, an n-type semiconductor layer 11 containing diamond is formed (Step S310). Before forming the n-type semiconductor layer 11, an intermediate semiconductor layer 13 may be formed.

By subjecting the n-type semiconductor layer 11 to a treatment, an intermediate layer 30 is formed (Step S320). This intermediate layer 30 contains at least a carbide. This carbide contains carbon contained in the n-type semiconductor layer 11. In an example useful for understanding the present invention, this intermediate layer 30 contains at least any of graphite, graphene, and amorphous carbon.

On a part of the intermediate layer 30, an electrode (first electrode 40) is formed (Step S330). By doing this, a semiconductor device according to the embodiment can be formed.

The treatment in the above Step S320 includes, for example, at least any of heating of the n-type semiconductor layer 11, introduction of an ion into the n-type semiconductor layer 11, and a surface treatment of the n-type semiconductor layer 11. By this treatment, the intermediate layer 30 can be formed on the surface of the n-type semiconductor layer 11. As the above ion, at least any of Ti, Si, Al, W, Ni, Cr, Ca, Li, Ru, Mo, Zr, Sr, Co, Rb, K, Cu, and Na can be used.

In the specification, "a state in which it is formed thereon" not only includes a state in which it is formed in direct contact therewith, but also includes a state in which another element is formed therebetween and it is formed thereon.

According to the embodiment, a semiconductor device having a high breakdown voltage and a method for manufacturing the same can be provided.

In this specification, "perpendicular" and "parallel" include not only strictly perpendicular and strictly parallel but also, for example, the fluctuation due to manufacturing processes, etc.; and it is sufficient to be substantially perpendicular and substantially parallel.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in the semiconductor devices such as p-type semiconductor layers, intermediate semiconductor layers, n-type semiconductor layers, first electrodes, second electrodes, intermediate layers, and insulating layers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included. The scope of protection of the present invention is only defined by the appended claims.

While certain embodiments have been described, these embodiments have been presented by way of example only, and are not intended to limit the scope of the invention as claimed. Indeed, the novel embodiments described herein may be embodied in a variety of other forms; furthermore, various omissions, substitutions and changes in the form of the embodiments described herein may be made without departing from the scope of the invention as claimed. The accompanying claims and their equivalents are intended to cover such forms or modifications as would fall within the scope of the invention as claimed.

### [Reference Signs List]

10u...stacked body, 11...n-type semiconductor layer, 11f... n-type diamond layer, 11s...side surface, 12...p-type semiconductor layer, 13...intermediate semiconductor layer, 13f...undoped intrinsic semiconductor diamond layer, 30... intermediate layer, 30f...TiC layer, 31...first region, 32...second region, 40...first electrode, 40s...portion, 41...first portion, 42...second portion, 50...second electrode, 60...insulating layer, 70...metal film, 110, 111, 112...semiconductor device

## Claims

1. A semiconductor device (110, 112), comprising:
a p-type semiconductor layer (12) containing diamond;
a first electrode (40) comprising at least any of the elements Ti, Si, Al, W, Ni, Cr, Ca, Li, Ru, Mo, Zr, Sr, Co, Rb, K, Cu, and Na;
an n-type semiconductor layer (11), provided between the p-type semiconductor layer (12) and the first electrode (40), the n-type semiconductor layer containing diamond, wherein the first electrode (40) comprises a first portion (41) and a second portion (42) provided around the first portion (41) when projected on a plane perpendicular to a direction from the n-type semiconductor layer (11) to the first electrode (40);
an insulating layer (60); and
an intermediate layer (30) including
a first region (31) provided between the first portion (41) of the first electrode (40) and the n-type semiconductor layer (11), and
a second region (32) provided around the first region (31) when projected on said plane, the second region (32) not overlapping the first portion (41) of the first electrode (40), and the second region (32) being continuous with the first region (31), wherein at least a part of the insulating layer (60) is disposed between the second portion (42) of the first electrode (40) and the second region (32);
**characterized in that** the first region (31) contains a carbide containing carbon and one of said elements contained in said first electrode (40), and the second region (32) contains a carbide containing carbon and an element contained in the insulating layer (60).

2. The semiconductor device (110) according to claim 1, wherein
the second portion (42) of the first electrode (40) is continuous with the first portion (41) of that electrode.

3. The semiconductor device (110) according to claim 2, wherein
the n-type semiconductor layer (11) has a side surface (11s) intersecting the plane,
the first electrode (40) includes a portion (40s) facing the side surface (11s), and
the insulating layer (60) extends between the side surface (11s) and the portion (40s) facing the side surface.

4. The semiconductor device (110) according to any preceding claim , wherein the insulating layer (60) contains at least any of silicon oxide, silicon nitride, aluminum oxide, aluminum nitride, zirconium oxide, hafnium oxide, and titanium oxide.

5. The semiconductor device (110) according to any preceding claim, wherein
the insulating layer (60) contains silicon oxide,
the first region (31)contains TiC, and
the second region (32) contains SiC.

6. The semiconductor device (110, 112) according to any one of claims 1 to 5, wherein a thickness of the intermediate layer is 1 nm or more and 10 nm or less.

7. The semiconductor device (110, 112) according to any one of claims 1 to 6, wherein the first region (31) and the second region (32) are in contact with the n-type semiconductor layer (11).

8. The semiconductor device (110, 112) according to any one of claims 1 to 7, wherein the device (110, 112) further comprises a second electrode (60) electrically connected to the p-type semiconductor layer (12).

9. The semiconductor device (110, 112) according to claim 8, wherein
the n-type semiconductor layer (11) is disposed between the first electrode (40) and the second electrode (50), and
the p-type semiconductor layer (12) is disposed between the n-type semiconductor layer (11) and the second electrode (50).

10. The semiconductor device (110, 112) according to any one of claims 1 to 9, further comprising an intermediate semiconductor layer (13) provided between the p-type semiconductor layer (12) and the n-type semiconductor layer (11), the intermediate semiconductor layer (13) containing diamond,
an impurity concentration in the intermediate semiconductor layer (13) being lower than an impurity concentration in the p-type semiconductor layer (12).

11. The semiconductor device (110, 112) according to any one of claims 1 to 9, further comprising an intermediate semiconductor layer (13) of an intrinsic semiconductor, the intermediate semiconductor layer (13) being provided between the p-type semiconductor layer (12) and the n-type semiconductor layer (11), and the intermediate semiconductor layer (13) containing diamond.

12. A method for manufacturing a semiconductor device (110, 112), comprising:
forming an n-type semiconductor layer (11) containing diamond on a p-type semiconductor layer (12) containing diamond;
forming an insulating layer (60) on a part of the n-type semiconductor layer (11);
forming a second carbide layer (32) containing carbon contained in the n-type semiconductor layer (11) and an element contained in the insulating (60) layer by performing a heat treatment;
forming a film containing at least any of the elements Ti, Si, Al, W, Ni, Cr, Ca, Li, Ru, Mo, Zr, Sr, Co, Rb, K, Cu, and Na on the n-type semiconductor layer (11) not covered with the insulating layer (60); and
forming a first carbide layer (31), containing carbon and one of said elements from said film containing at least any of Ti, Si, Al, W, Ni, Cr, Ca, Li, Ru, Mo, Zr, Sr, Co, Rb, K, Cu, and Na, between the n-type semiconductor layer (11) not covered with the insulating layer (60) and said film by subjecting the film to a treatment.

13. The method for manufacturing a semiconductor device (110, 112) according to claim 12, wherein the treatment includes heating of the film.

## Patentansprüche

1. Halbleitervorrichtung (110, 112), Folgendes umfassend:
eine p-Typ-Halbleiterschicht (12), welche Diamant enthält;
eine erste Elektrode (40), welche mindestens eines der Elemente Ti, Si, Al, W, Ni, Cr, Ca, Li, Ru, Mo, Zr, Sr, Co, Rb, K, Cu und Na umfasst;
eine n-Typ-Halbleiterschicht (11), welche zwischen der p-Typ-Halbleiterschicht (12) und der ersten Elektrode (40) bereitgestellt ist, wobei die n-Typ-Halbleiterschicht Diamant enthält, wobei die erste Elektrode (40) einen ersten Abschnitt (41) und einen zweiten Abschnitt (42) umfasst, welcher rund um den ersten Abschnitt (41) bereitgestellt ist, wenn er in einer Ebene rechtwinklig zu einer Richtung von der n-Typ-Halbleiterschicht (11) zu der ersten Elektrode (40) projiziert wird;
eine isolierende Schicht (60); und
eine Zwischenschicht (30), welche Folgendes einschließt:
einen ersten Bereich (31), welcher zwischen dem ersten Abschnitt (41) der ersten Elektrode (40) und der n-Typ-Halbleiterschicht (11) bereitgestellt ist, und
einen zweiten Bereich (32), welcher rund um den ersten Bereich (31) bereitgestellt ist, wenn er auf die Ebene projiziert wird, wobei der zweite Bereich (32) den ersten Abschnitt (41) der ersten Elektrode (40) nicht überlappt, und wobei der zweite Bereich (32) kontinuierlich mit dem ersten Bereich (31) ist, wobei mindestens ein Teil der isolierenden Schicht (60) zwischen dem zweiten Abschnitt (42) der ersten Elektrode (40) und dem zweiten Bereich (32) angeordnet ist;
**dadurch gekennzeichnet, dass** der erste Bereich (31) ein kohlenstoffhaltiges Karbid und eines der in der ersten Elektrode (40) enthaltenen Elemente enthält, und der zweite Bereich (32) ein kohlenstoffhaltiges Karbid und ein in der isolierenden Schicht (60) enthaltenes Element enthält.

2. Halbleitervorrichtung (110) nach Anspruch 1, wobei:
der zweite Abschnitt (42) der ersten Elektrode (40) kontinuierlich mit dem ersten Abschnitt (41) dieser Elektrode ist.

3. Halbleitervorrichtung (110) nach Anspruch 2, wobei:
die n-Typ-Halbleiterschicht (11) eine Seitenfläche (11s) aufweist, welche die Ebene kreuzt,
die erste Elektrode (40) einen Abschnitt (40s) einschließt, welcher der Seitenfläche (11s) zugewandt ist, und
die isolierende Schicht (60) sich zwischen der Seitenfläche (11s) und dem der Seitenfläche zugewandten Abschnitt (40s) erstreckt.

4. Halbleitervorrichtung (110) nach einem der vorhergehenden Ansprüche, wobei die isolierende Schicht (60) mindestens eines von Siliziumoxid, Siliziumnitrid, Aluminiumoxid, Aluminiumnitrid, Zirkonoxid, Hafniumoxid und Titanoxid enthält.

5. Halbleitervorrichtung (110) nach einem der vorhergehenden Ansprüche, wobei:
die isolierende Schicht (60) Siliziumoxid enthält,
der erste Bereich (31) TiC enthält, und
der zweite Bereich (32) SiC enthält.

6. Halbleitervorrichtung (110, 112) nach einem der Ansprüche 1 bis 5, wobei eine Dicke der Zwischenschicht 1 nm oder mehr und 10 nm oder weniger beträgt.

7. Halbleitervorrichtung (110, 112) nach einem der Ansprüche 1 bis 6, wobei der erste Bereich (31) und der zweite Bereich (32) in Kontakt mit der n-Typ-Halbleiterschicht (11) stehen.

8. Halbleitervorrichtung (110, 112) nach einem der Ansprüche 1 bis 7, wobei die Vorrichtung (110, 112) ferner eine zweite Elektrode (60) umfasst, welche elektrisch mit der p-Typ-Halbleiterschicht (12) verbunden ist.

9. Halbleitervorrichtung (110, 112) nach Anspruch 8, wobei:
die n-Typ-Halbleiterschicht (11) zwischen der ersten Elektrode (40) und der zweiten Elektrode (50) angeordnet ist, und
die p-Typ-Halbleiterschicht (12) zwischen der n-Typ-Halbleiterschicht (11) und der zweiten Elektrode (50) angeordnet ist.

10. Halbleitervorrichtung (110, 112) nach einem der Ansprüche 1 bis 9, ferner umfassend eine Halbleiterzwischenschicht (13), welche zwischen der p-Typ-Halbleiterschicht (12) und der n-Typ-Halbleiterschicht (11) bereitgestellt ist, wobei die Halbleiterzwischenschicht (13) Diamant enthält, wobei
eine Verunreinigungskonzentration in der Halbleiterzwischenschicht (13) geringer als eine Verunreinigungskonzentration in der p-Typ-Halbleiterschicht (12) ist.

11. Halbleitervorrichtung (110, 112) nach einem der Ansprüche 1 bis 9, ferner umfassend eine Halbleiterzwischenschicht (13) aus einem intrinsischen Halbleiter, wobei die Halbleiterzwischenschicht (13) zwischen der p-Typ-Halbleiterschicht (12) und der n-Typ-Halbleiterschicht (11) bereitgestellt ist, und die Halbleiterzwischenschicht (13) Diamant enthält.

12. Verfahren zum Herstellen einer Halbleitervorrichtung (110, 112), welches Folgendes umfasst:
Bilden einer Diamant enthaltenden n-Typ-Halbleiterschicht (11) an einer Diamant enthaltenden p-Typ-Halbleiterschicht (12);
Bilden einer isolierenden Schicht (60) an einem Teil der n-Typ-Halbleiterschicht (11);
Bilden einer zweiten Karbidschicht (32), welche Kohlenstoff enthält, welcher in der n-Typ-Halbleiterschicht (11) enthalten ist und ein Element, welches in der isolierenden (60) Schicht enthalten ist, durch Durchführung einer Wärmebehandlung;
Bilden eines Films, welcher mindestens eines der Elemente Ti, Si, Al, W, Ni, Cr, Ca, Li, Ru, Mo, Zr, Sr, Co, Rb, K, Cu und Na enthält, an der nicht mit der isolierenden Schicht (60) bedeckten n-Typ-Halbleiterschicht (11); und
Bilden einer ersten Karbidschicht (31), welche Kohlenstoff und eines der Elemente aus dem Film enthält, welcher mindestens eines von Ti, Si, Al, W, Ni, Cr, Ca, Li, Ru, Mo, Zr, Sr, Co, Rb, K, Cu und Na enthält, zwischen der nicht mit der isolierenden Schicht (60) bedeckten n-Typ-Halbleiterschicht (11) und dem Film, durch Unterwerfen des Films einer Behandlung.

13. Verfahren zur Herstellung einer Halbleitervorrichtung (110, 112) nach Anspruch 12, wobei die Behandlung Erhitzen des Films einschließt.

## Revendications

1. Dispositif à semi-conducteur (110, 112), comprenant :
une couche semi-conductrice de type p (12) contenant du diamant,
une première électrode (40) comprenant au moins l'un quelconque des éléments Ti, Si, Al, W, Ni, Cr, Ca, Li, Ru, Mo, Zr, Sr, Co, Rb, K, Cu et Na,
une couche semi-conductrice de type n (11), agencée entre la couche semi-conductrice de type p (12) et la première électrode (40), la couche semi-conductrice de type n contenant du diamant, dans lequel la première électrode (40) comprend une première partie (41) et une seconde partie (42) agencée autour de la première partie, lorsqu'elle est projetée sur un plan perpendiculaire à une direction de la couche semi-conductrice de type n (11) à la première électrode (40),
une couche isolante (60), et
une couche intermédiaire (30) incluant :
une première région (31) fournie entre la première partie (41) de la première électrode (40) et la couche semi-conductrice de type n (11), et
une seconde région (32) fournie autour de la première région (31), lorsqu'elle est projetée sur ledit plan, la seconde région (32) ne recouvrant pas la première partie (41) de la première électrode (40), et la seconde région (32) étant en continuité avec la première région (31), dans lequel au moins une partie de la couche isolante (60) est disposée entre la seconde partie (42) de la première électrode (40) et la seconde région (32),
**caractérisé en ce que** la première région (31) contient un carbure contenant du carbone et un desdits éléments contenus dans ladite première électrode (40), et la seconde région (32) contient un carbure contenant du carbone et un élément contenu dans la couche isolante (60).

2. Dispositif à semi-conducteur (110) selon la revendication 1, dans lequel la seconde partie (42) de la première électrode (40) est en continuité avec la première partie (41) de cette électrode.

3. Dispositif à semi-conducteur (110) selon la revendication 2, dans lequel :
la couche semi-conductrice de type n (11) a une surface latérale (11s) entrecroisant le plan,
la première électrode (40) inclut une partie (40s) tournée vers la surface latérale (11s), et
la couche isolante (60) s'étend entre la surface latérale (11s) et la partie (40s) tournée vers la surface latérale.

4. Dispositif à semi-conducteur (110) selon l'une quelconque des revendications précédentes, dans lequel la couche isolante (60) contient au moins l'un quelconque parmi de l'oxyde de silicium, du nitrure de silicium, de l'oxyde d'aluminium, du nitrure d'aluminium, de l'oxyde de zirconium, de l'oxyde d'hafnium et de l'oxyde de titane.

5. Dispositif à semi-conducteur (110) selon l'une quelconque des revendications précédentes, dans lequel :
la couche isolante (60) contient de l'oxyde de silicium,
la première région (31) contient du TiC, et
la seconde région (32) contient du SiC.

6. Dispositif à semi-conducteur (110, 112) selon l'une quelconque des revendications 1 à 5, dans lequel l'épaisseur de la couche intermédiaire est supérieure ou égale à 1 nm et inférieure ou égale à 10 nm.

7. Dispositif à semi-conducteur (110, 112) selon l'une quelconque des revendications 1 à 6, dans lequel la première région (31) et la seconde région (32) sont en contact avec la couche semi-conductrice de type n (11).

8. Dispositif à semi-conducteur (110, 112) selon l'une quelconque des revendications 1 à 7, dans lequel le dispositif (110, 112) comprend en outre une seconde électrode (60) connectée électriquement à la couche semi-conductrice de type p (12).

9. Dispositif à semi-conducteur (110, 112) selon la revendication 8, dans lequel :
la couche semi-conductrice de type n (11) est disposée entre la première électrode (40) et la seconde électrode (50), et
la couche semi-conductrice de type p (12) est disposée entre la couche semi-conductrice de type n (11) et la seconde électrode (50).

10. Dispositif à semi-conducteur (110, 112) selon l'une quelconque des revendications 1 à 9, comprenant en outre une couche semi-conductrice intermédiaire (13) agencée entre la couche semi-conductrice de type p (12) et la couche semi-conductrice de type n (11), la couche semi-conductrice intermédiaire (13) contenant du diamant, et
une concentration d'impuretés dans la couche semi-conductrice intermédiaire (13) étant inférieure à une concentration d'impuretés dans la couche semi-conductrice de type p (12).

11. Dispositif à semi-conducteur (110, 112) selon l'une quelconque des revendications 1 à 9, comprenant en outre une couche semi-conductrice intermédiaire (13) d'un semi-conducteur intrinsèque, la couche semi-conductrice intermédiaire (13) étant agencée entre la couche semi-conductrice de type p (12) et la couche semi-conductrice de type n (11), et la couche semi-conductrice intermédiaire (13) contenant du diamant.

12. Procédé de fabrication d'un dispositif à semi-conducteur (110, 112) comprenant :
la formation d'une couche semi-conductrice de type n (11) contenant du diamant sur une couche semi-conductrice de type p (12) contenant du diamant,
la formation d'une couche isolante (60) sur une partie de la couche semi-conductrice de type n (11),
la formation d'une seconde couche de carbure (32) contenant du carbone contenu dans la couche semi-conductrice de type n (11) et un élément contenu dans la couche isolante (60) en exécutant un traitement thermique,
la formation d'un film contenant au moins l'un quelconque des éléments Ti, Si, Al, W, Ni, Cr, Ca, Li, Ru, Mo, Zr, Sr, Co, Rb, K, Cu et Na sur la couche semi-conductrice de type n (11) non recouverte par la couche isolante (60), et
la formation d'une première couche de carbure (31), contenant du carbone et l'un des dits éléments dudit film contenant au moins l'un quelconque parmi Ti, Si, Al, W, Ni, Cr, Ca, Li, Ru, Mo, Zr, Sr, Co, Rb, K, Cu et Na, entre la couche semi-conductrice de type n (11) non recouverte par la couche isolante (60) et ledit film, en soumettant le film à un traitement.

13. Procédé de fabrication d'un dispositif à semi-conducteur (110, 112) selon la revendication 12, dans lequel le traitement inclut le chauffage du film.
